Europäisches Patentamt

European Patent Office

Office européen des brevets

(11) Publication number: **0 034 107**
A1

## (12) EUROPEAN PATENT APPLICATION

(21) Application number: 81630002.4

(22) Date of filing: 06.01.81

(51) Int. Cl.³: **H 03 K 13/18**

(30) Priority: 11.02.80 US 120450

(71) Applicant: **UNITED TECHNOLOGIES CORPORATION, 1, Financial Plaza, Hartford, CT 06101 (US)**

(72) Inventor: **Snitzer, Elias, 11 Fox Meadow Lane, West Hartford CT 06107 (US)**
Inventor: **Green, William Jackson, Jr., 33 Echo Ridge Drive, Vernon CT 06066 (US)**

(43) Date of publication of application: 19.08.81
Bulletin 81/33

(74) Representative: **Waxweiler, Jean et al, OFFICE DENNEMEYER S.à.r.l. 21-25 Allée Scheffer P.O.Box 41, Luxembourg (LU)**

(84) Designated Contracting States: FR GB

(54) **Optical encoder using time domain multi-plexer.**

(57) An optical encoder having a single light source and single light receiver transcribes signal information imprinted on an optical mask in the form of light transmissive or opaque regions in a plurality of signal bit locations into a serial, real time optical pulse signal in which the presence or absence of an optical pulse in each of a plurality of successive pulse window time intervals defines the signal state of successive signal bit locations, by multiplexing a light source pulse into a temporal array of secondary light pulses, one for each signal bit of the optical mask and each presented to the associated signal bit in a related one of successive pulse window time intervals, the optical receiver detecting the presence or absence of a secondary light pulse in each successive interval and providing signal manifestation in the form of electrical signal bits corresponding to the signal state of the data word imprinted on the optical mask.

FIG. 2

Description

Optical Encoder Using Time Domain Multiplexing

Technical Field

This invention relates to optical encoders, and more particularly to time domain multiplexed fiber optic encoders.

Background Art

Optical encoders utilizing fiber optics are well known in the art, such devices providing optical interrogation and readout of information encoded on an optical mask. The information is imprinted on the mask in the form of multiple binary signal bits with the binary state characterized by the light transmissive or opaque state of the associated signal bit locations between two major surfaces of the mask. The transparent signal bits provide a complete light transmission path between the surfaces of the mask from a light source, such as a light emitting diode (LED) or laser diode (LD) which provide the light to the associated bit through a fiber optic path or waveguide, to a light receiver, such as an optical detector which receives the light through a similar fiber optic path. The opaque regions provide interruption of the light path. The light transmission, or non-transmission through the mask determines the particular signal bit logic state, i.e. one or zero.

In the simplest embodiment, for a mask having an N number of signal bits there are N light sources and N light receivers, each with its associated fiber optic path. The sources and detector are arranged in pairs, one pair dedicated to each signal bit location. The number of light sources and associated fiber optic

0034107

paths can be reduced by using a single light source of appropriate intensity to illuminate all of the signal bits at one time, with the presence or absence of light through individual signal bit locations being determined by individual light detectors associated with each bit. Alternatively a single light receiver and path may be used with N number of separate light sources; the individual light sources being sequenced to discriminate between signal bit locations. In this manner the number of light sources or light receivers, together with their fiber optic paths, may be reduced to one; but not both.

Signal multiplexing may be used to reduce the number of both light sources and receivers to less than N as disclosed in U. S. Patent 4,117,460, of common assignee herewith, issued to Walworth et al. As shown by Walworth et al, the N signal bit locations of the mask are connected through N fiber optic paths to $N^{\frac{1}{2}}$ light receivers and light detectors arranged so as to provide, in effect, a square matrix of equal rows and columns; one light source for each column and one light detector for each row. Each source is activated to provide column illumination and the light detectors are polled to detect the presence or absence of light at particular signal bit row location. This reduces both the number of sources and receivers required, although it does not permit use of a single light source with a single light receiver, nor does it reduce the number of fiber optic paths required to provide light transmission to the N signal bit locations of the mask.

Disclosure of Invention

Objects of the present invention include providing an optical encoder having the absolute minimum number of both light sources and light receivers, together with a proportionate reduction in the number of fiber optic paths required for transcribing signal information encoded in the form of light transmissive or opaque regions in each of a plurality of parallel signal bit locations between two major surfaces of an optical mask.

According to the present invention, an optical encoder transcribes the imprint of the signal information on the mask into a serial signal bit stream by time domain multiplexing; a single light pulse, i.e. a primary pulse is divided into a temporal array of secondary light pulses, one for each signal bit location, each presented in timed sequence to the associated parallel bit location at a first major surface of the optical mask in a related one of successive pulse window time intervals; the timed transmission of each secondary pulse through the mask parallel bit locations are multiplexed into a real time serial signal stream of light pulses and presented to an optical receiver which provides a signal manifestation in response to the presence of each secondary pulse, the presence or absence of a signal manifestation in each successive pulse window time interval providing a serial signal representation of the mask encoded information.

In further accord with the present invention, the temporal array of secondary light pulses is provided by dividing the primary light pulse from the source into a plurality of secondary light pulses in an optical power splitter which provides each of the secondary pulses simultaneously to an associated one of a plurality of fiber optic delay lines, the delay lines providing successively, from a first line associated with a first bit location on the mask to a last line associated with a last bit location on the mask, increased propagation time delays so as to provide the plurality of equal time spaced secondary light pulses at the outputs thereof, from a first pulse to a last pulse corresponding to the signal bit locations of the mask.

In still further accord with the present invention the primary light pulse is provided at a selected real time pulse width T and the delay lines comprise different length fiber optic waveguides of the same material, each succeeding waveguide, from a first one to a last one, being longer than a preceding waveguide by a length corresponding to at least one spatial pulse width as determined by the product of the real time pulse width T and the group velocity of the light pulses in the particular fiber optic material.

The optical encoder of the present invention allows the use of a single light source, a single receiver, and the fiber optic paths associated with each, to transpose encoded information from a plurality of signal bit locations on an optical mask. The conversion of the parallel signal bit information on the mask into a serial stream of time spaced light pulses further allows the transcribed information to be transmitted to the light detector over a single, common waveguide. This provides both a reduction in the number of required fiber optic paths and also a significant increase in encoder reliability due to the fact that disruption of the serial signal caused by waveguide failure provides total interruption of the signal and, therefore, an absolute indication of failure. This is in contrast to the loss of individual signal bits as may occur in the prior art devices where parallel transmission occurs over multiple fibers and signal error is not readily obvious. These and other objects, features and advantages of the present invention will become more apparent in the light of the following detailed description of an exemplary embodiment thereof, as illustrated in the accompanying drawing.

Brief Description of Drawing

Fig. 1 is a simplified perspective illustration, not to scale, of the optical encoder of the present invention as used in combination with a fiber optic position sensor;

Fig. 2 is a simplified, system block diagram of the optical encoder of the present invention;

Fig. 3 is an illustration of the operating characteristics of the optical encoder of Figs. 1, 2; and

Fig. 4 is an illustration of an alternative embodiment of one element used in the optical encoder of Fig. 2.

Best Mode for Carrying Out the Invention

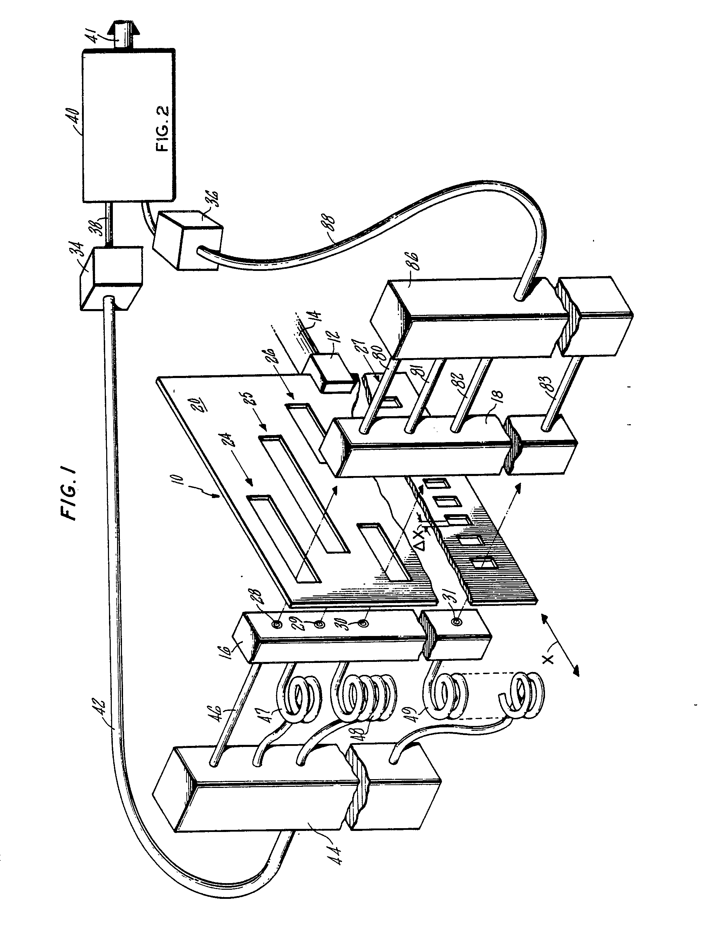

Referring to Fig. 1, in a perspective illustration of the optical encoder of the present invention as may be used in a fiber optic position sensor of the type disclosed in U. S. Patent 4,116,000, of common assignee herewith, issued to Martin et al, a position sensor code plate 10 is attached through a mechanical connector 12 and shaft 14 to the device whose position is to be sensed, allowing the code plate to be displaced through a light transmission path established between a light transmitting block 16 and light receiving block 18. The code plate includes an optical mask 20 encoded with a plurality of signal bit locations 24-27 which, for the selected Gray code illustrated, corresponds to a plurality (N) of signal channels. The Gray code provides signal information of the linear displacement at granularity intervals $\Delta X$ and, for a given stationary position of the mask in the light transmission path, provides a unique optical signal code by virtue of the transparent or opaque regions presented by the signal bit in each channel. It should be understood that although illustrated for use with a linear fiber optic position sensor the optical encoder of the present invention is not limited to such use, and may be used with any type of encoded optical mask, including angle measuring masks.

The transmitting and receiving blocks each include an equal plurality of light ways, which represent the termination of fiber optic paths in each block. The light ways are disposed on the face of each block in a linear array, along an axis coincident with the signal bit locations to be read from the optical mask. The transmitting block includes light ways 28-31, each in registration with an associated one of the signal bit locations 24-27. The receiving block light ways (not shown in Fig. 1) are similarly arrayed, such that each receiving block light way is in registration with a counterpart located in the transmitting block and light from the transmitting block light ways is received by the associated receiving light way in the absence of interruption of the particular light path.

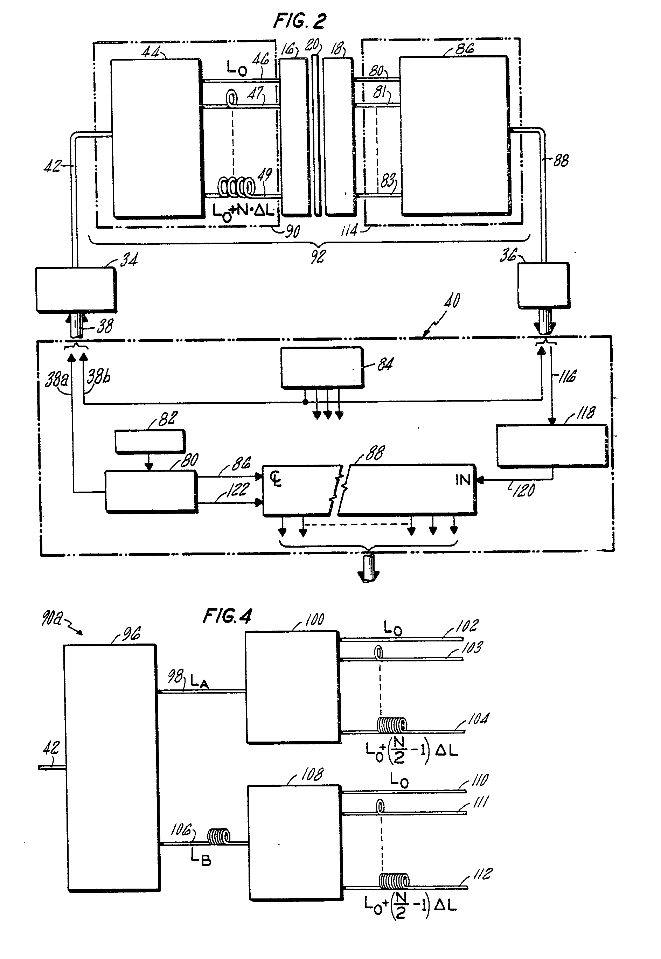

The description thus far is typical of prior art encoders, and particularly those used in combination with a fiber optic position sensor of the type disclosed by Martin et al. In the optical encoder of the present invention a single pulsed light source 34 and single light receiver 36 are used to provide full transposition of the mask encoded information into an optical signal. The pulsed light source is turned on in response to a gate signal provided on lines 38 from control and signal conditioning circuitry 40, described in detail hereinafter with respect to Fig. 2, and when gated on provides a light pulse of intensity I, with a real time pulse width (T) determined by the duration of the applied gate signal. The source light pulse, or primary pulse is transmitted through a single fiber optic path, or waveguide 42 to an optical power splitter 44 which divides the light intensity of the source pulse into N number of secondary light pulses corresponding to the number of signal bit locations to be transcribed from the optical mask. In Fig. 1, N = 4 (signal bit locations 24 through 27), however, any number of secondary pulses may be provided with a light source of sufficient intensity and multiple port splitters, such as star couplers of the type known in the art for use in optical communication systems for providing radial distribution of multiplexed, data bus optical signals as disclosed by T. G. Giallorenzi in a paper entitled Optical Communications Research and Technology: Fiber Optics, Proceedings of the IEEE, Vol. 66, No. 7, July 1978.

The secondary light pulses have a spatial pulse width, i.e. the spatial distance occupied by the source light pulse of real time pulse width (T) propagating at the group velocity ($V_g$) through the optical waveguide 42. As known the group velocity is equal to: $V_g = \frac{C}{n_g}$; where C is the velocity of light in free space, or $3 \times 10^8 \frac{meters}{sec}$, and $n_g$ is the group index of refraction for the material media (core and cladding) of the waveguide. In the absence of dispersion the spatial pulse width (P) is equal to: $P = T \cdot V_g$. For the short length runs of waveguides used in the present encoder the dispersion effects are negligible. Each secondary light pulse has a spatial pulse width equal to that of the source pulse, and each are presented simultaneously from the star coupler 44 to one end of an associated one of a plurality (N) of optical delay lines 46-49, the other ends of which are terminated in an associated one of the light ways 28-31 of the transmitter block 16. The delay lines are fiber optic waveguides of the same material, but of different length. The line lengths (L) increase successively, beginning with a first delay line (46) to the last, or Nth line (49), in successive, substantially equal increment length values ($\Delta$L). For a line 46 length $L_0$, the length of the next line 47 is $L_1 = L_0 + \Delta L$, the line 48 has a length $L_2 = L_1 + \Delta L$, and so on up to the last line of length $L_N = L_{N-1} + \Delta L$. This incremental length $\Delta L$ is selected to provide at least one full spatial pulse width between successive delay lines, and is typically twice the spatial pulse width of the secondary optical pulses. For a primary, or source pulse having a real time bandwidth of T = 10 nanoseconds and propagating through a doped fused quartz (silicon dioxide) fiber optic waveguide having a group index of refraction of 1.46: the group velocity is $2.05 \times 10^8 \, \frac{meters}{sec}$, the spatial pulse width is 2.05 meters, and the value of $\Delta$L is on the order of 4 meters. The $\Delta$L value is selected to provide sufficient temporal separation of the secondary light pulses at the face of the transmitting block 16, such that the higher the value of $\Delta$L the greater the time separation between adjacent pulses.

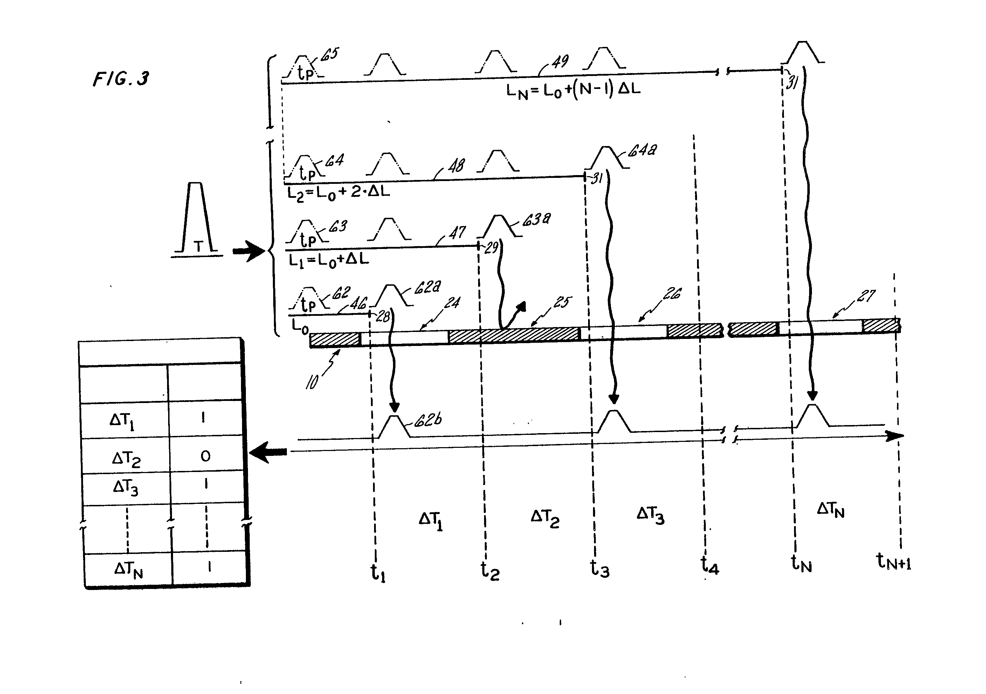

Referring now to Fig. 3, in a simplified, time based illustration of the time domain multiplexing for the optical encoder of the present invention, the primary light pulse 60 with real time pulse width T is divided by the star coupler (44, Fig. 1) into N secondary pulses 62-65 which are presented simultaneously to the inputs of the associated delay lines 46-49 (Figs. 1, 3). The line lengths for the lines 46-49 are illustrated as $L_0$ through $L_n$, each succeeding line being longer than the immediately preceding line in the array by the value $\Delta$L. As a result the propagation time for each secondary pulse increases with succeeding delay lines by a real time increment

$$\Delta T = \frac{\Delta L}{V_g} \, .$$

For the first line 46, the secondary pulse 62 is incident ($62_a$) at the light way 28 of the transmitting block 16 at time $t_1$. In the presence of a light transmissive path through the associated signal bit location 24, the pulse propagates through the code plate 10 and is incident ($62_b$) at the receiver block 18. The pulse 63 on the line 47 is incident ($63_a$) at the transmitter light way 29 at time $t_2$, where $t_2 - t_1 = \Delta T_1$, the time duration of the pulse window interval, i.e. the difference time delay between successive delay lines. For the assumed opaque region of signal bit location 25 the pulse is prevented from propagating through the mask to the receiver within the $\Delta T_3$ pulse window interval, the upper limit of which ($t_3$) is the time that the succeeding pulse 64 is incident ($64_a$) at the light way 30 and propagates through the mask bit location 26 to the receiving block. If the presence or absence of a light pulse at the receiver is designated 1 or 0, then for intervals $\Delta T_1 - \Delta T_3$ the received intelligence is 101. Each succeeding pulse similarly appears at the face of the transmitting block in successive, equal $\Delta T$ intervals and, depending on the encoded signal bit location associated with each either appears at the receiver or is blocked by the code plate. The light incident at the receiver, therefore, appears as a real time series signal of light pulses in the nature of a serial signal bit stream, where the presence or absence of a light pulse in a given time interval provides a manifestation of the signal state of the associated one of the signal bit locations. The position of a given pulse in the serial stream beginning with the first pulse ($62_b$), together with the known value $\Delta T$ intervals in which the presence or absence of a light pulse should occur, allows for immediate identification of the signal state of each signal bit location. Since the information encoded on the code plate 10 is in

0034107

- 10 -

binary form (transparent or opaque) the series light pulses appear directly in binary form, as illustrated by the table of Fig. 3.

Referring again to Fig. 1, the light pulses received at the light ways of the receiving block 18 are transported in parallel through an associated one of the signal bit fiber optic waveguides 80-83 to a common junction, or connector 86. Each of the signal bit waveguides are of essentially equal length and provide an equal transport time delay for each pulse, such that successive, received pulses appear at the connector at essentially the same ΔT pulse window intervals. The connector couples the received pulses as they appear on the parallel signal bit waveguides into a single, common waveguide 88 and these two elements together function as a signal combiner which multiplexes each pulse propagating through the mask into the serial optical pulse signal illustrated in Fig. 3. The waveguide 88 presents the serial signal to the light receiver 36.

The actual configuration of the signal combiner, i.e. the combination junction and common fiber optic waveguide 88, may be provided in a number of different element configurations, which are selectable based on the particular applied use of the encoder. These include the use of a star coupler for the connector 86 in combination with a single channel, single fiber waveguide (88), or the use of a simple connector 86 which connects the signal bit waveguides either to a single channel multiple fiber waveguide 88, or to a single channel single fiber waveguide (88) having a fiber core diameter which is large enough to allow light registration with all of the signal bit waveguide cores. In each of these configurations the parallel received pulses are converted into the serial light pulse stream which is presented to the detector.

Referring now to Fig. 2, in a block diagram illustration of the present optical encoder the control and signal conditioning circuitry 40 (Fig. 1) includes control logic 80 responsive to a clock 82 which provides the system time base. The control logic provides gate signals on a line $38_a$ included within the lines 38 (Fig. 1) together with the voltage excitation from a voltage source 84 provided on lines $38_b$, to the pulsed light source, or optical transmitter 34 (Fig. 1). The gate signals are at a selected pulse repetition frequency (PRF) and real time pulse width (T). For delay line $\Delta L$ values providing a plural number (M) of spatial pulse width intervals of delay between successive secondary light pulses, the resultant time separation, or "pulse window" time interval $\Delta T = M \cdot T$ and the signal bit frequency $F = \frac{1}{\Delta T}$. The total cycle time for an N signal bit encoder $Ts = N \cdot \Delta T$ and the $PRF = \frac{1}{T_s}$. For the assumed: T = 10 nanoseconds (ns), and a two spatial pulse width separation between delay lines (M = 2), the pulse window time interval $\Delta T = 20$ nanoseconds and the signal bit frequency $F = 50 \times 10^6$ bits per second (50 MBps). For a twelve signal bit encoder (N = 12) the cycle time $T_s = 240$ ns and the PRF is approximately 4.2 MHz.

The frequency of the clock 84 is selected to provide a time base interval equal to the pulse window time interval $\Delta T$. This time base signal is provided on a line 86 from the control logic 82 to an N bit shift register 88 which, as described hereinafter, may provide serial to parallel conversion of the series electrical pulse signal provided by the optical receiver.

The light source pulsed output is provided through single channel waveguide 42 to the transmitter portion 90 of the time domain multiplexer 92; this portion includes the star coupler 44 and the delay lines (46-49, Fig. 1) which in combination provide the temporal array of secondary light pulses. In applications where the mask encoded information is provided in higher order bit counts, i.e. greater number of signal bit locations, the transmitter portions may include multiple star couplers or optical power splitters, which allow for a reduction in the total length of optic fiber required for the delay lines. This may be important from the standpoint of encoder size since the $\Delta L$ lengths are in multiple numbers of meters such that the $N \cdot \Delta L$ lengths may become excessive. This alternate embodiment of the transmitter portion is shown in Fig. 4 where the primary pulse from the waveguide 42 is input to a first optical signal splitter 96 of the alternate embodiment transmitter $90_a$. The splitter divides the primary pulse in two and provides a first divided pulse through a waveguide 98 of length $L_A$ to the input of a second splitter, or star coupler 100. The star coupler 100 has $\frac{N}{2}$ outputs, each connected to an associated one of $\frac{N}{2}$ delay lines 102-104 of increasing $\Delta L$ values from a first line 102 of length $L_0$ to the last line 104 having a length $L_0 + \left(\frac{N}{2}-1\right)\Delta L$. A second pulse from the splitter 96 is coupled through waveguide 106 having a length $L_B = L_A + \frac{N}{2} \cdot \Delta L$, to a star coupler 108; the transport delay for the second pulse, from the second output of the splitter 96 to the star coupler 108, is equal to the time delay of the last delay line (106) of the first star coupler plus the line length ($L_A$) of the first waveguide 98. The second star coupler 108 also has $\frac{N}{2}$ outputs, each connected to an associated one of the delay lines 110 through 112, where the absolute lengths of the lines 110-112 are equal to the lines 102 through 104. This allows for a significant reduction in total fiber optic lengths, the absolute savings being dependent on the number (N) of bits and the selected number (M) of spatial pulse widths of separation, i.e. ΔL.

The outputs from the transmitter portion 90 are presented through the transmitter block 16 to the mask 20. The secondary pulses propagating through the mask are incident at the receiver block 18 and presented to the receiver portion 114 of the multiplexer 92. The receiver portion includes the signal bit fiber optic waveguides 80-83, the optical connector 86, and the common, single channel waveguide 88; the connector 86 and waveguide 88 comprising the optical signal combiner which may be provided in any of the element combinations described hereinbefore. The output of the receiver portion is the real time serial signal stream of light pulses which is presented through the waveguide 88 to the optical detector 36.

The optical detector transduces the light intensity of each received secondary pulse into a proportional magnitude voltage signal which is presented through lines 116 to the control circuit 40, and received at a threshold detector 118, of a type known in the art. The threshold voltage limits are selectable, and are established for the particular application. The signal output from the detector, which is a series pulse stream, may be signal conditioned within the general threshold detection circuitry to provide any selected signal processor compatible format. The output signal pulses from the threshold detector are presented through lines 120 to the input of the shift register 88 which shifts in the signal at the input in succeeding ΔT intervals as established by the clock signal on a line 86; the presence or absence of a pulse in each interval corresponding to a one or zero logic state respectively. In this manner the appearance of the signal at the output from the threshold detector is uniquely defined as associated with a known $\Delta T$ interval beginning with the first interval corresponding to the first secondary pulse of the temporal array presented to the optical mask assembly. This allows identification of the presence or absence of a signal within a given $\Delta T$ interval as being associated with a given one of the signal bit locations of the optical mask.

The synchronization of the $\Delta T$ time base on the lines 88 with the pulse window time intervals for the temporal array of secondary pulses is provided for the particular application by clearing and inhibiting the shift register for a fixed transport time delay, defined as the time interval between the pulsed turn on of the light source 34 and the time at which the secondary pulse associated with the first signal bit location of the mask may be expected to appear at the output of the threshold detector. This is achieved by the control logic 80 which enables the shift register with a gate signal on the line 122 at the end of the transport time delay following the gate on of the light source. The shift register, which may include a number of shift registers in cascade depending on the total number of signal bits to be decoded, provides the transcribed data from the N number of signal locations as N bits of information, from a least significant bit (LSB) to a most significant bit (MSB), which is provided on the lines 41 (Fig. 1) as the output from the optical card reader.

The present optical encoder allows for the reduction of the number of required light sources, light receivers, and fiber optic paths to an absolute minimum through the use of passive time domain multiplexing in which a single source light pulse is used to optically encode signal information from a plurality of signal bit locations on an optical mask. The light source and receiver may be remotely located from the multiplexer and mask, with the interconnection between them being provided by single channel fiber optic waveguides for the source and receiver. As such the present encoder may be ideally suited for use with a position sensor which, in engine control applications, must be located in a hostile temperature and vibration environment; the passive optical multiplexer being capable of withstanding temperature and vibration extremes.

The encoder elements are those which are known in the art. The star couplers required are similar to those presently used in optical communication systems. The light sources and light receivers required are also available, with the particular device selected, being dependent on the light intensity and light sensitivity requirements of the particular application; the light sources including light emitting diodes (LED) and CW or pulsed laser diodes, and the light receivers including an avalanche photodiode (APD) or a PIN diode. Similarly the electronic control circuitry for converting the comparatively high frequency (50 MBps) optical bit rate into an equivalent, processor compatible format is similar to that which is presently used in optical telecommunications, as described in a paper by T. L. Maione et al entitled _Practical 45-MBps Regenerator for Lightwave Transmission_; The Bell Systems Technical Journal, Vol. 57, July-August 1978, Pps 1837-1856.

Although the invention has been shown and described with respect to illustrated embodiments thereof, it should be understood by those skilled in the art that the foregoing and various other changes, omissions and additions in the form and detail thereof may be made therein without departing from the spirit and the scope of the invention.

- 16 -

0034107

## Claims

1. An optical signal encoder for transcribing signal information imprinted as light transmissive or opaque regions in a plurality of signal bit locations between two major surfaces of an optical mask, comprising:

pulsed light source means for providing primary light pulses at a selected real time pulse width;

as characterized by:

time domain multiplexer means, including a transmitter portion and a receiver portion, said transmitter portion being responsive to said primary light pulses for dividing each into a temporal array of secondary light pulses, one for each signal bit location, each presented by said transmitter portion to the associated bit location on a first major surface of the mask in a related one of a plurality of successive pulse window time intervals, said receiver portion being responsive to the signal bit locations on the other major surface of the mask for providing a series signal summation of said secondary light pulses propagating therethrough in each successive pulse window interval; and

light receiver means, responsive to said series signal for providing a signal manifestation in response to the presence of each received secondary pulse and for not providing said signal manifestation in the absence thereof, the presence or absence of said signal manifestations in each successive pulse window time interval providing a serial signal representation of the information imprinted on the optical mask.

- 17 -

0034107

2.   The optical encoder of claim 1, wherein said multiplexer means transmitter portion comprises:

optical power splitting means, connected for response to said pulsed light source means, for dividing each primary light pulse into a plurality of secondary light pulses of equal real time pulse width, said power splitting means providing each of said secondary pulses simultaneously at a related one of a plurality of outputs thereof; and

plurality of optical delay lines, one for each signal bit location, each disposed to provide optical communication therethrough between the associated signal bit location and a related one of the plurality of outputs of said power splitting means, each succeeding one of said delay lines, from a first line associated with a first signal bit location to a last line associated with a last signal bit location, providing a light propagation time delay greater than that provided by a preceding line, the difference time delay between succeeding lines being equal to said pulse window time interval.

3.   The optical encoder of claim 2, wherein the difference time delay between succeeding optical delay lines is greater than said real time pulse width of said primary light pulse.

4.   The optical encoder of claim 2, wherein said plurality of optical delay lines comprise fiber optic waveguides having the same group index of refraction, each providing an equal group velocity to said secondary light pulses propagating therethrough, each succeeding delay line from said first line to said last line being longer than the preceding delay line by a minimum length difference value equal to the product of said real time pulse width multiplied by said group velocity.

5. The optical encoder of claims 2 or 4, wherein said multiplexer means receiver portion comprises:

plurality of signal bit fiber optic waveguides, each connected for response at one end thereof to an associated one of said signal bit locations on said other major surface of the optical mask, and each providing a substantially equal propagation time delay for said secondary light pulses propagating therethrough; and

signal combiner means, connected for response at a plurality of inputs thereof to the other ends of said plurality of signal bit fiber optic waveguides, for combining serially said secondary light pulses received in parallel from all of said signal bit waveguides in succeeding pulse window time intervals to provide said series signal summation at an output thereof to said light receiver means.

6. The optical encoder of claim 5, wherein said signal combiner comprises:

star coupler means, connected at each of a plurality of input ports to said other end of an associated one of said plurality of signal bit fiber optic waveguides, for providing a substantially equal signal insertion loss characteristic to each of said secondary light pulses received from said waveguides at each port, said coupler combining said equally attenuated secondary pulses serially into said series signal summation at an output thereof; and

single channel waveguide means, connected at one end thereof to said output of said coupler means for providing a common light propagation path for said series signal summation therethrough to said light receiver means.

0034107

7.    The optical encoder of claim 1, further characterized by:

clock means, for providing a clock signal having a time period equal to that of said pulse window time interval;

shift register means, connected for response to the output of said light receiver means and responsive to said clock signal from said clock means; and

encoder control means, for providing in one or more succeeding pulse repetition periods, a first gate signal to said light source means for energizing said source for a time equal to the selected real time pulse width of said primary light pulse and, after a transport time delay interval following presentation of said first gate signal to said light source, providing a second gate signal to said shift register means to enable said register means at a time coincident with presentation of a first secondary pulse to a first signal bit location in a first pulse window interval, said register means providing, in each succeeding clock signal period in the presence of said enable gate signal, registration of the presence and absence of said signal manifestations from said light receiver means in each succeeding pulse window time interval as determined by successive periods of said clock signal.

0034107

81630002.4

FIG. I

FIG. 2

0034107

**FIG. 2**

$L_O$

$L_O + N \cdot \Delta L$

**FIG. 4**

$L_O$

$L_O + \left(\frac{N}{2} - 1\right) \Delta L$

$L_A$

$L_B$

$L_O$

$L_O + \left(\frac{N}{2} - 1\right) \Delta L$

FIG.3

$L_N = L_0 + (N-1)\Delta L$

$L_2 = L_0 + 2 \cdot \Delta L$

$L_1 = L_0 + \Delta L$

$L_0$

| | |
|---|---|
| $\Delta T_1$ | 1 |
| $\Delta T_2$ | 0 |
| $\Delta T_3$ | 1 |
| | |
| $\Delta T_N$ | 1 |

$\Delta T_1$    $\Delta T_2$    $\Delta T_3$    $\Delta T_N$

$t_1$   $t_2$   $t_3$   $t_4$   $t_N$   $t_{N+1}$

0034107

0034107
Application number

EP 81 63 0002

## European Patent Office

## EUROPEAN SEARCH REPORT

| | DOCUMENTS CONSIDERED TO BE RELEVANT | | CLASSIFICATION OF THE APPLICATION (Int. Cl.³) |
|---|---|---|---|
| Category | Citation of document with indication, where appropriate, of relevant passages | Relevant to claim | |
| X | GB - A - 1 540 907 (STANDARD TELEPHONES AND CABLES)<br><br> * Page 2, lines 46-85; figure 4 *<br><br>---- | 1-5 | H 03 K 13/18 |

TECHNICAL FIELDS
SEARCHED (Int. Cl.³)

H 03 K 13/18
G 01 D  5/26
        5/34
        5/32
        5/249
        5/252

CATEGORY OF
CITED DOCUMENTS

X: particularly relevant

A: technological background

O: non-written disclosure

P: intermediate document

T: theory or principle underlying the invention

E: conflicting application

D: document cited in the application

L: citation for other reasons

&: member of the same patent family, corresponding document

The present search report has been drawn up for all claims

| Place of search | Date of completion of the search | Examiner |
|---|---|---|
| The Hague | 18-05-1981 | GUIVOL |

EPO Form 1503.1  06.78